# EUROPEAN PATENT SPECIFICATION

(11) **EP 3 486 664 B1**
(45) Date of publication and mention of the grant of the patent: **05.05.2021**
(21) Application number: 17827166.4
(22) Date of filing: 13.03.2017
(51) Int. Cl.: G01R 15/20

(54) **CURRENT SENSOR**
STROMSENSOR
CAPTEUR DE COURANT

(30) Priority: 15.07.2016 JP 2016140928
(43) Date of publication of application: 22.05.2019
(73) Proprietor: Alps Alpine Co., Ltd., Tokyo 145-8501 (JP)
(72) Inventor: TAMURA, Manabu, Tokyo 145-8501 (JP); MATSUE, Ken, Tokyo 145-8501 (JP); HEBIGUCHI, Hiroyuki, Tokyo 145-8501 (JP)
(74) Representative: Maiwald Patent- und Rechtsanwaltsgesellschaft mbH
(86) International application number: PCT/JP2017/009926
(87) International publication number: WO 2018/012032

(56) References cited:
- WO-A1-2015/178478
- WO-A1-2016/190087
- JP-A- 2014 160 035
- JP-A- 2015 111 079
- JP-A- 2015 194 349
- JP-A- 2016 125 907
- JP-A- 2017 040 591
- US-A1- 2013 187 633

## Description

### Technical Field

The present invention relates to a current sensor according to claim 1.

### Background Art

JP 2016 125907 A describes a current sensor which measures current flowing in each of a plurality of bus bars.

US 2013/187633 A1 describes a current sensor including at least three bus bars made of flat-plate-shape conductors.

A known current sensor detects, by using a magnetic sensor disposed near a wire, a magnetic field generated by a current flowing through the wire. In the case where a measurement target is a wire having a larger diameter than the size of the magnetic sensor, the directions of vectors of a magnetic flux near the magnetic sensor do not significantly change even when the magnetic sensor is shifted in the direction perpendicular to the direction in which the current flows.

### Citation List

### Patent Literature

PTL 1: Japanese Unexamined Patent Application Publication No. 2015-111079
PTL 2: Japanese Unexamined Patent Application Publication No. 2014-77682

### Summary of Invention

### Technical Problem

However, as described in PTL 1, in the case where the measurement target is a wire having a smaller thickness than the width thereof in section, an oval magnetic flux line is formed around the wire. Accordingly, there exists a disadvantage in that the directions of the vectors of the magnetic flux near the magnetic sensor significantly change even with a slight shift of the magnetic sensor, which is disposed on one end side in the width direction, in the thickness direction.

In order to address this, there exists a method of reducing the influence of shifting of the position of a magnetic sensor by, as described in PTL 2, disposing an annular core so as to surround a wire and disposing a magnetic sensor at a cut of the core formed in a magnetic path. However, when the current flowing through the wire is large, for exact measurement of the magnetic field, it is required to use a core having a large sectional area. Thus, there exists a disadvantage in that the size and cost of the current sensor increase.

The present invention is made in view of the above-described situation. An object of the present invention is to provide a size-reduced current sensor that can suppress the influence of a shift in position so as to detect a magnetic field with high accuracy.

### Solution to Problem

According to the present invention, a current sensor includes a wire, a magnetic sensor, at least one magnetic field shaping member, and a securing member. The wire has a thickness in a first direction and a width which is in a second direction perpendicular to the first direction and which is larger than the thickness. The magnetic sensor detects a magnetic field generated by a current flowing through the wire. The at least one magnetic field shaping member includes a soft magnetic material and shapes the magnetic field. The securing member secures the wire, the magnetic sensor, and the at least one magnetic field shaping member. The at least one magnetic field shaping member is a plate-shaped member extending substantially parallel to a plane perpendicular to the second direction. The at least one magnetic field shaping member includes an outer surface facing the magnetic sensor. A direction along the outer surface and a direction of a sensitivity axis of the magnetic sensor are substantially parallel to the first direction. The securing member secures the magnetic sensor and the at least one magnetic field shaping member on the same side in the second direction relative to the wire such that the magnetic sensor and the at least one magnetic field shaping member are located close to each other. The securing member secures the wire, the magnetic sensor, and the at least one magnetic field shaping member such that the wire, the magnetic sensor, and the at least one magnetic field shaping member are kept separated from one another in the second direction while at least part of the wire, at least part of the magnetic sensor, and at least part of the at least one magnetic field shaping member are superposed on one another in the second direction.

With this structure, vectors of a magnetic flux near the magnetic sensor are stabilized by the at least one magnetic field shaping member. Thus, even when the magnetic sensor and the at least one magnetic field shaping member, which are secured to each other, are slightly shifted in position relative to the wire, the vectors of the magnetic flux near the magnetic sensor are unlikely to change. As a result, even when the position of the magnetic sensor relative to the wire slightly changes, a change in the sensitivity of the magnetic sensor can be suppressed. Thus, compared to the case where a core is used, the size can be reduced while the influence of the positional shift can be suppressed, and accordingly, the magnetic field can be detected with high accuracy.

In the current sensor according to the present invention, preferably, the magnetic sensor is disposed near or at a center of the at least one magnetic field shaping member in the first direction.

With this structure, the magnetic sensor is disposed near or at the center of the at least one magnetic field shaping member in the first direction. Thus, the magnetic sensor is disposed at a position where many components of the magnetic flux are parallel to the direction of the sensitivity axis. As a result, compared to the case where the magnetic sensor is disposed at a position other than the above-described position, the change in the sensitivity of the magnetic sensor occurring due to the positional shift of the wire and the magnetic sensor from each other can be suppressed.

In the current sensor according to the present invention, preferably, a width of the at least one magnetic field shaping member in the first direction is larger than the thickness of the wire in the first direction.

With this structure, the width of the at least one magnetic field shaping member in the first direction is larger than the thickness of the wire in the first direction. Thus, with the at least one magnetic field shaping member, the change in the sensitivity of the magnetic sensor due to the positional shift of the wire and the magnetic sensor from each other can be suppressed even in the case where the influence of the positional shift of the wire and the magnetic sensor from each other in the first direction would be significant without the at least one magnetic field shaping member.

In the current sensor according to the present invention the at least one magnetic field shaping member is positioned between the wire and the magnetic sensor.

With this structure, the at least one magnetic field shaping member is positioned between the wire and the magnetic sensor. Thus, compared to the case where the at least one magnetic field shaping member is not provided, the magnetic flux density near the magnetic sensor is small, and accordingly, measurement up to a high current can be performed with the magnetic sensor.

In the current sensor according to the present invention, preferably, the magnetic sensor is positioned between the wire and the at least one magnetic field shaping member.

With this structure, the magnetic sensor is positioned between the wire and the at least one magnetic field shaping member. Thus, the size can be reduced compared to the case where the at least one magnetic field shaping member is disposed at the same position, that is, the at least one magnetic field shaping member is disposed between the wire and the magnetic sensor. Furthermore, since the magnetic field is unlikely to be blocked by the at least one magnetic field shaping member, the signal-to-noise ratio can be reduced, and accordingly, a small change of the magnetic field is likely to be detected by the magnetic sensor.

In the current sensor according to the present invention, preferably, the at least one magnetic field shaping member includes two magnetic field shaping members, and the magnetic sensor is positioned between one of the magnetic field shaping members and another magnetic field shaping member.

With this structure, the magnetic field shaping members are positioned between the wire and the magnetic sensor. Thus, compared to the case where the magnetic field shaping members are not provided, the magnetic flux density near the magnetic sensor is small, and accordingly, measurement up to a high current can be performed with the magnetic sensor. Furthermore, the magnetic field shaping members are disposed on both sides of the magnetic sensor. Thus, compared to the case where a single magnetic field shaping member is provided, the change in the vectors of the magnetic flux near the magnetic sensor due to a positional shift is insignificant.

In the current sensor according to the present invention, preferably, the securing member includes a first substrate and a second substrate, the at least one magnetic field shaping member is secured to the first substrate, the magnetic sensor is secured to the second substrate, and the first substrate and the second substrate are secured to each other by heat welding.

With this structure, the first substrate to which the at least one magnetic field shaping member is secured and the second substrate to which the magnetic sensor secured are separately prepared. Thus, compared to the case where the at least one magnetic field shaping member and the magnetic sensor are secured to a single substrate, versatility of design can be increased. Since the first substrate and the second substrate are secured to each other by heat welding, the at least one magnetic field shaping member and the magnetic sensor can be secured with high positional accuracy.

### Advantageous Effects of Invention

According to the present invention, the size reduction can be realized while the influence of the positional shift can be suppressed, and accordingly, the magnetic field can be detected with high accuracy.

### Brief Description of Drawings

[Fig. 1] Fig. 1 is a perspective view of a current sensor according to a first embodiment of the present invention.
[Fig. 2] Fig. 2 is a sectional view of the current sensor taken along line 2-2 of Fig. 1.
[Fig. 3] Fig. 3 is a schematic view illustrating the relationships between a magnetic sensor and vectors of a magnetic flux when the center of a wire and the center of the magnetic sensor are substantially coincident with each other in a comparative example.
[Fig. 4] Fig. 4 is a schematic view illustrating the relationships between the magnetic sensor and the vectors of the magnetic flux when the center of the wire and the center of the magnetic sensor are shifted from each other in the comparative example.
[Fig. 5] Fig. 5 is a schematic view illustrating the relationships between the magnetic sensor and the vectors of the magnetic flux and when the center of the wire and the center of the magnetic sensor are substantially coincident with each other in the first embodiment.
[Fig. 6] Fig. 6 is a schematic view illustrating the relationships between the magnetic sensor and the vectors of the magnetic flux when the center of the wire and the center of the magnetic sensor are shifted from each other in the first embodiment.
[Fig. 7] Fig. 7 includes graphs illustrating the relationships between a positional shift and a sensitivity error in an experiment.
[Fig. 8] Fig. 8 is a sectional view of part of a structure according to a first variation.
[Fig. 9] Fig. 9 is a sectional view of part of a structure according to a second variation.
[Fig. 10] Fig. 10 is a sectional view of a current sensor according to a second embodiment of the present invention.
[Fig. 11] Fig. 11 is a sectional view of a current sensor according to a third embodiment of the present invention.

### Description of Embodiments

### (First Embodiment)

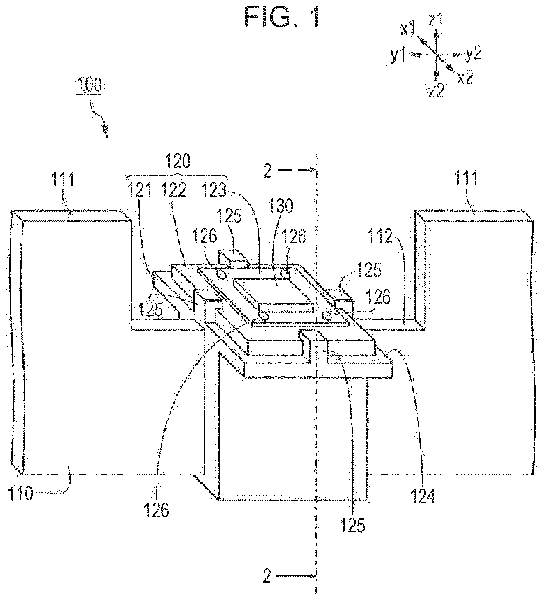

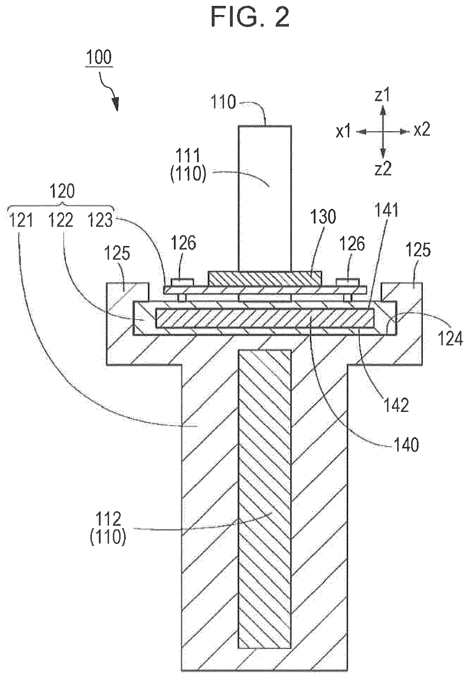

A current sensor according to a first embodiment will be described below. Fig. 1 is a perspective view of a current sensor 100 according to the present embodiment. Fig. 2 is a sectional view of the current sensor 100 taken along a section passing through line 2-2 of Fig. 1 and parallel to the xz plane.

Herein, the x direction, the y direction, and the z direction which are perpendicular to one another are defined. The x direction refers to the x1 direction and the x2 direction oppositely directed to each other without distinguishing the x1 direction and the x2 direction from each other. The y direction refers to the y1 direction and the y2 direction oppositely directed to each other without distinguishing the y1 direction and the y2 direction from each other. The z direction refers to the z1 direction and the z2 direction oppositely directed to each other without distinguishing the z1 direction and the z2 direction from each other. These directions are defined for convenience when relative positional relationships are described and do not restrict the directions in actual use. Regardless of whether or not the shape of any element is described with a modifier such as "substantial" or "substantially", the shape of the element is not limited to an exact geometric shape based on the described expression as long as the technical thought of the embodiment disclosed herein is realized.

As illustrated in Fig. 2, the current sensor 100 includes a wire 110, a securing member 120, a magnetic sensor 130, and a magnetic field shaping member 140. The width of the wire 110 in the z direction is larger than the thickness of the wire 110 in the x direction. The magnetic sensor 130 detects a magnetic field generated by a current flowing through the wire 110. The magnetic field shaping member 140 includes a soft magnetic material and shapes the magnetic field. The securing member 120 secures the wire 110, the magnetic sensor 130, and the magnetic field shaping member 140.

### (The Wire)

As illustrated in Fig. 1, the wire 110 linearly extends in the y direction near the magnetic sensor 130. The wire 110 according to the present embodiment is a bus bar placed in an inverter. The wire 110 includes a normal region 111 having a specified width in the z direction and a narrow region 112 provided at part of the normal region 111 in the middle of the normal region 111 in the y direction. The width of the narrow region 112 in the z direction is smaller than the width of the normal region 111 in the z direction. An end edge of the narrow region 112 on the z2 side is, in the y direction, formed linearly from and continuous with an end edge of the normal region 111 on the z2 side. An end edge of the narrow region 112 on the z1 side is, in the z direction, formed at a different position from an end edge of the normal region 111 on the z1 side. As illustrated in Fig. 2, when seen in the section parallel to the xz plane, the narrow region 112 has a substantially rectangular parallelepiped shape having sides extending along the x direction or the z direction.

### (The Securing Member)

As illustrated in Fig. 1, the securing member 120 includes a main securing member 121, a first substrate 122, and a second substrate 123. The securing member 120 is formed of an insulating material.

The main securing member 121 is in close contact with and surrounds the narrow region 112 by a specified length in the y direction. The main securing member 121 has an upper surface 124 on the z1 side relative to the end edge of the narrow region 112 on the z1 side. The upper surface 124 is parallel to the xy plane. The main securing member 121 has four claws 125 that project in the z1 direction from the upper surface 124.

The first substrate 122 is a flat plate-shaped member extending parallel to the xy plane and can be secured to the upper surface 124 by using the claws 125 of the main securing member 121. As illustrated in Fig. 2, the magnetic field shaping member 140, which will be described later, is embedded inside and secured to the first substrate 122. The first substrate 122 and the main securing member 121 are detachably attached to each other. As illustrated in Fig. 1, the second substrate 123 is a flat plate-shaped member extending parallel to the xy plane on the z1 side relative to the first substrate 122. The magnetic sensor 130, which will be described later, is secured to a surface of the second substrate 123 on the z1 side.

The securing member 120 further includes four bosses 126. The first substrate 122 and the second substrate 123 are secured to each other by heat welding during the production by using four bosses 126. The second substrate 123 is heat welded on the z1 side relative to the first substrate 122. Since there is a gap between the first substrate 122 and the second substrate 123, generated heat is likely to escape.

### (The Magnetic Sensor)

The magnetic sensor 130 illustrated in Fig. 2 includes a magnetoelectric conversion element such as a magnetoresistive sensor or a Hall element. The magnetic sensor 130 has a shape that is symmetric about a plane parallel to the yz plane. The direction of the sensitivity axis of the magnetic sensor 130 is the x direction. The center of the magnetic sensor 130 in the x direction is coincident with the center of the wire 110 in the x direction. The magnetic sensor 130 is disposed on the z1 side relative to the wire 110 such that the magnetic sensor 130 is kept separated from the wire 110.

### (The Magnetic Field Shaping Member)

The magnetic field shaping member 140 is positioned between the wire 110 and the magnetic sensor 130 in the z direction. The magnetic field shaping member 140 is a plate-shaped member extending substantially parallel to the xy plane inside the first substrate 122. The magnetic field shaping member 140 has a substantially rectangular parallelepiped shape having surfaces, and each of the surfaces of the magnetic field shaping member 140 is parallel to one of the xy plane, yz plane, and the xz plane. The magnetic field shaping member 140 has a first outer surface 141 parallel to the xy plane and located on the z1 side and a second outer surface 142 parallel to the xy plane and located on the z2 side. The first outer surface 141 faces the magnetic sensor 130. Both the direction along the first outer surface 141 and the direction of the sensitivity axis of the magnetic sensor 130 (that is, the x direction) are substantially parallel to the x direction. The second outer surface 142 faces the wire 110.

### (Relative Positional Relationships)

The securing member 120 secures the magnetic sensor 130 and the magnetic field shaping member 140 on the same side in the z direction (that is, on the z1 side) relative to the wire 110 such that the magnetic sensor 130 and the magnetic field shaping member 140 are located close to each other. The magnetic field shaping member 140 is positioned between the wire 110 and the magnetic sensor 130. The magnetic field shaping member 140 is disposed near or at the center of the wire 110 in the x direction. The magnetic sensor 130 is disposed near or at the center of the magnetic field shaping member 140 in the x direction. That is, in the x direction, the center of the wire 110, the center of the magnetic sensor 130, and the center of the magnetic field shaping member 140 are substantially coincide with one another.

The securing member 120 secures the wire 110, the magnetic sensor 130, and the magnetic field shaping member 140 such that the wire 110, the magnetic sensor 130, and the magnetic field shaping member 140 are kept separated from one another while at least part of the wire 110, at least part of the magnetic sensor 130, and at least part of the magnetic field shaping member 140 are superposed on one another in the z direction. The widths of the magnetic sensor 130 and the magnetic field shaping member 140 in the x direction are larger than the thickness of the wire 110 in the x direction. The width of the magnetic field shaping member 140 in the x direction is larger than the width of the magnetic sensor 130 in the x direction. The magnetic sensor 130 is not superposed on the magnetic field shaping member 140 in the x direction.

### (Magnetic Field)

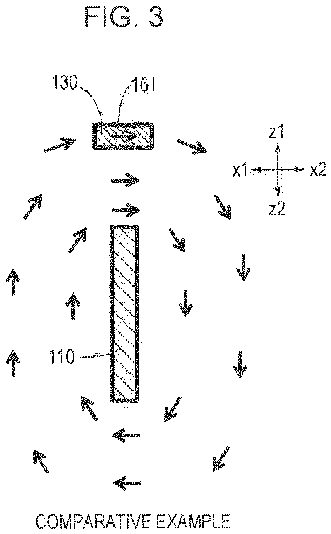

Fig. 3 is a schematic view illustrating the relationships between the magnetic sensor 130 and vectors of a magnetic flux generated by the current flowing through the wire 110 according to a comparative example in which the magnetic field shaping member 140 is not provided. In the case of Fig. 3, the center of the wire 110 and the center of the magnetic sensor 130 are substantially coincide with each other in the x direction. Accordingly, the direction of the vector of the magnetic flux in the magnetic sensor 130 (direction indicated by an arrow 161) is substantially parallel to the x direction.

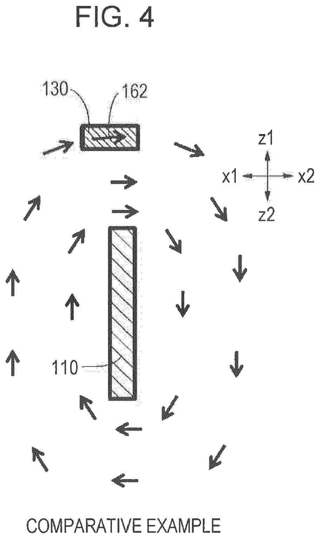

Fig. 4 is a schematic view illustrating the relationships between the magnetic sensor 130 and the vectors of the magnetic flux generated by the current flowing through the wire 110 according to the comparative example in which the magnetic field shaping member 140 is not provided. In the case of Fig. 4, the center of the magnetic sensor 130 is shifted in the x direction from the center of the magnetic sensor 110 to a position further in the x1 direction. For example, when the wire 110 as a bus bar is connected to a device requiring a high current such as an inverter, such a shift is generated by thermal expansion of the elements of the current sensor 100 and components around the current sensor 100 due to the current flowing through the wire 110.

The width of the wire 110 in the z direction is larger than the thickness of the wire in the x direction. Thus, even when a position in the z direction changes, the vectors of the magnetic flux do not significantly change on both sides of the wire 110 in the x direction. In contrast, when a position in the x direction changes, the directions of the vectors of the magnetic flux significantly change on both sides of the wire 110 in the z direction. Accordingly, in the example of Fig. 4, the direction of the vector of the magnetic flux in the magnetic sensor 130 (direction indicated by an arrow 162) is not parallel to the x direction. As a result, the x-direction component of the vector of the magnetic flux reduces compared to the case illustrated in Fig. 3. Thus, even when the current of the same magnitude as that of Fig. 3 flows through the wire 110, a detection value reduces.

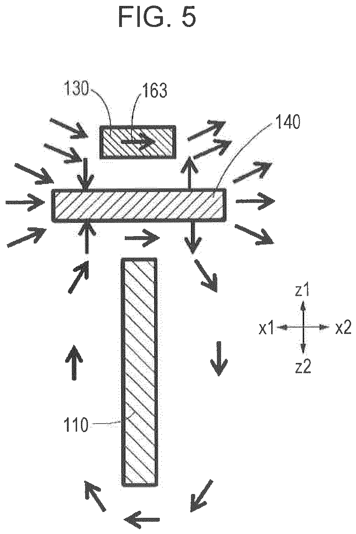

Fig. 5 is a schematic view illustrating the relationships between the magnetic sensor 130 and the vectors of the magnetic flux generated by the current flowing through the wire 110 according to the present embodiment in which the magnetic field shaping member 140 is provided. In the case of Fig. 5, the center of the wire 110, the center of the magnetic sensor 130, and the center of the magnetic field shaping member 140 are substantially coincide with one another in the x direction. Since the entirety of a structure including these components is symmetric about a plane passing through the center in the x direction and parallel to the yz plane, the vectors of the magnetic flux is also symmetric about the same plane. Accordingly, the direction of the magnetic field in the magnetic sensor 130 (direction indicated by an arrow 163) is substantially parallel to the x direction.

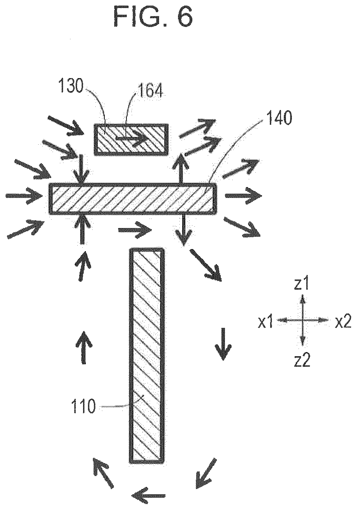

Fig. 6 is a schematic view illustrating the relationships between the magnetic sensor 130 and the vectors of the magnetic flux generated by the current flowing through the wire 110 according to the present embodiment in which the magnetic field shaping member 140 is provided. In the case of Fig. 6, the center of the magnetic sensor 130 and the center of the magnetic field shaping member 140 in the x direction are shifted from the center of the magnetic sensor 110 in the x direction to a position further in the x1 direction. The center of the magnetic sensor 130 and the center of the magnetic field shaping member 140 are substantially coincide with each other in the x direction. The magnetic sensor 130 and the magnetic field shaping member 140, which are secured to each other by heat welding during the production at the securing member 120, do not significantly shift from each other. However, since the magnetic sensor 130 and the magnetic field shaping member 140 are detachably attached to the wire 110, the magnetic sensor 130 and the magnetic field shaping member 140 may shift from the wire 110 due to thermal expansion or the like.

The magnetic field shaping member 140, which is formed of a soft magnetic material, has a large force to shape a magnetic field therearound. Compared to the case where the magnetic field shaping member 140 is not provided, the vectors of the magnetic field around the magnetic field shaping member 140 do not significantly change even when the magnetic field shaping member 140 is slightly moved in the x direction. Since the magnetic sensor 130 is secured in the shaped magnetic field, the vectors of the magnetic flux near the magnetic sensor 130 do not significantly change between the case of Fig. 5 and the case of Fig. 6. That is, even when the positions of the magnetic sensor 130 and the wire 110 in the x direction are shifted from each other, the direction of the magnetic field in the magnetic sensor 130 (direction indicated by an arrow 164) is maintained substantially parallel to the x direction.

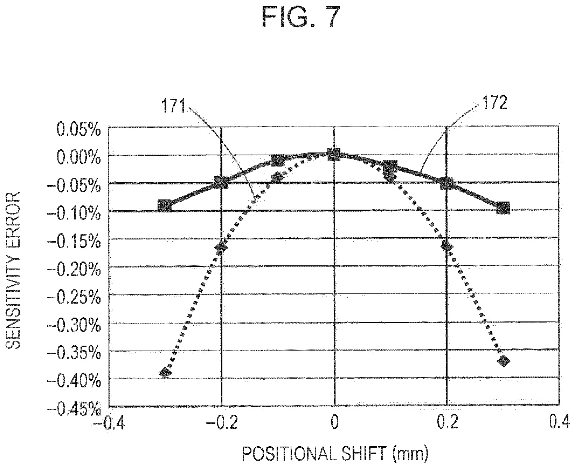

Fig. 7 includes graphs illustrating the relationships between a positional shift (horizontal axis) and a sensitivity error (vertical axis) in an experiment. For the positional shift, the shift of the center of the magnetic sensor 130 and the center of the wire 110 from each other in the x direction is represented in mm. For the sensitivity error, the rate of the amount of a change of a measured value with respect to a measured value when the positional shift is 0 mm is expressed in percent. When the measured value at a position is smaller than the measured value when the positional shift is 0 mm, the sensitivity error is represented in a negative value. It is assumed that, in Fig. 1, the width of the narrow region 112 in the z direction is 10 mm, the thickness of the narrow region 112 in the x direction is 2 mm, a gap between the magnetic field shaping member 140 and the wire 110 in the z direction is 1 mm, the thickness of the magnetic field shaping member 140 in the z direction is 1 mm, and a gap between the magnetic sensor 130 and the wire 110 in the z direction is 2.5 mm.

A graph 171 illustrates the case of the comparative example illustrated in Figs. 3 and 4. A graph 172 illustrates the case of the present embodiment illustrated in Figs. 5 and 6. In both the graph 171 and graph 172, as the positional shift increases, the sensitivity error reduces (that is, a deviation from the measured value when the positional deviation is 0 mm increases). The change in the sensitivity error is smaller in the case of the present embodiment (graph 172) than in the case of the comparative example (graph 171). That is, influence of the positional shift in the x direction on the measured value is smaller in the case of the present embodiment than in the case of the comparative example.

### (Summarization)

According to the present embodiment, the vectors of the magnetic flux near the magnetic sensor 130 are stabilized by the magnetic field shaping member 140. Thus, even when the magnetic sensor 130 and the magnetic field shaping member 140, which are secured to each other, are slightly shifted in position relative to the wire 110, the vectors of the magnetic flux near the magnetic sensor 130 are unlikely to change. As a result, even when the position of the magnetic sensor 130 relative to the wire 110 slightly changes, a change in the sensitivity of the magnetic sensor 130 can be suppressed. Thus, compared to the case where a core is used, the size can be reduced while the influence of the positional shift can be suppressed, and accordingly, the magnetic field can be detected with high accuracy.

According to the present embodiment, the magnetic sensor 130 is disposed near or at the center of the magnetic field shaping member 140 in the x direction. Thus, the magnetic sensor 130 is disposed at a position where many components of the magnetic flux are parallel to the direction of the sensitivity axis. As a result, compared to the case where the magnetic sensor 130 is disposed at a position other than the above-described position, the change in the sensitivity of the magnetic sensor 130 occurring due to the positional shift of the wire 110 and the magnetic sensor 130 from each other can be suppressed.

According to the present embodiment, the width of the magnetic field shaping member 140 in the x direction is larger than the thickness of the wire 110 in the x direction. Thus, with the magnetic field shaping member 140, the change in the sensitivity of the magnetic sensor 130 due to the positional shift of the wire 110 and the magnetic sensor 130 from each other can be suppressed even in the case where the influence of the positional shift of the wire 110 and the magnetic sensor 130 from each other in the x direction would be significant without the magnetic field shaping member 140.

According to the present embodiment, the magnetic field shaping member 140 is positioned between the wire 110 and the magnetic sensor 130. Thus, compared to the case where the magnetic field shaping member 140 is not provided, the magnetic flux density near the magnetic sensor 130 is small, and accordingly, measurement up to a high current can be performed with the magnetic sensor 130.

According to the present embodiment, the first substrate 122 to which the magnetic field shaping member 140 is secured and the second substrate 123 to which the magnetic sensor 130 is secured are separately prepared. Thus, compared to the case where the magnetic field shaping member 140 and the magnetic sensor 130 are secured to a single substrate, versatility of design can be increased. Since the first substrate 122 and the second substrate 123 are secured to each other by heat welding, the magnetic field shaping member 140 and the magnetic sensor 130 can be secured with high positional accuracy.

### (A First Variation of the First Embodiment)

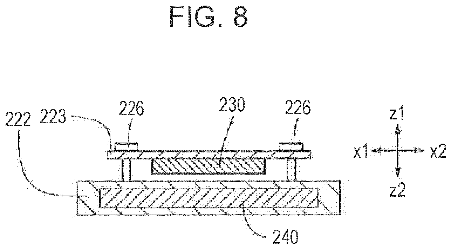

Fig. 8 is a sectional view of part of a first variation at the same section as the section of Fig. 2. According to the first variation, the first substrate 122, the second substrate 123, the bosses 126, the magnetic sensor 130, and the magnetic field shaping member 140 illustrated in Fig. 2 are respectively replaced with a first substrate 222, a second substrate 223, bosses 226, a magnetic sensor 230, and a magnetic field shaping member 240 illustrated in Fig. 8.

According to the first embodiment (Fig. 2), the magnetic sensor 130 is secured on the z1 side of the second substrate 123. In contrast, according to the first variation (Fig. 8), the magnetic sensor 230 is secured on the z2 side of the second substrate 223. Thus, the length of the bosses 226 according to the first variation (Fig. 8) is larger than that of the bosses 126 in the z direction according to the first embodiment (Fig. 2), and a gap between the first substrate 222 and the second substrate 223 in the z direction according to the first variation (Fig. 8) is larger than the gap between the first substrate 122 and the second substrate 123 in the z direction according to the first embodiment (Fig. 2). Other structures are similar to those of the first embodiment.

Also with the first variation, the relative positional relationships between the wire 110 illustrated in Fig. 2 and the magnetic field shaping member 240 and the magnetic sensor 230 illustrated in Fig. 8 are the same as those of the first embodiment. Accordingly, the effects similar to those of the first embodiment can be obtained.

### (A Second Variation of the First Embodiment)

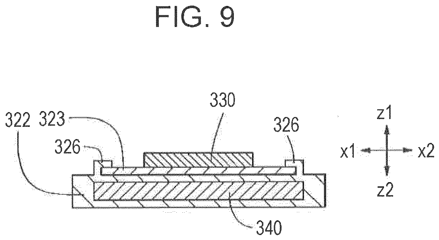

Fig. 9 is a sectional view of part of a second variation at the same section as the section of Fig. 2. According to the second variation, the first substrate 122, the second substrate 123, the bosses 126, the magnetic sensor 130, and the magnetic field shaping member 140 illustrated in Fig. 2 are respectively replaced with a first substrate 322, a second substrate 323, retaining claws 326, a magnetic sensor 330, and a magnetic field shaping member 340 illustrated in Fig. 9.

According to the first embodiment (Fig. 2), the second substrate 123 is secured to the first substrate 122 by using the bosses 126. In contrast, according to the second variation (Fig. 9), the second substrate 323 is secured to the first substrate 322 by using the retaining claws 326. Since a surface of the first substrate 122 on the z1 side and a surface of the second substrate 323 on the z2 side are in close contact with each other, the first substrate 122 and the second substrate 323 are more firmly secured to each other. Other structures are similar to those of the first embodiment.

Also with the second variation, the relative positional relationships between the wire 110 illustrated in Fig. 2 and the magnetic field shaping member 340 and the magnetic sensor 330 illustrated in Fig. 9 are the same as those of the first embodiment. Accordingly, the effects similar to those of the first embodiment can be obtained.

### (Second Embodiment)

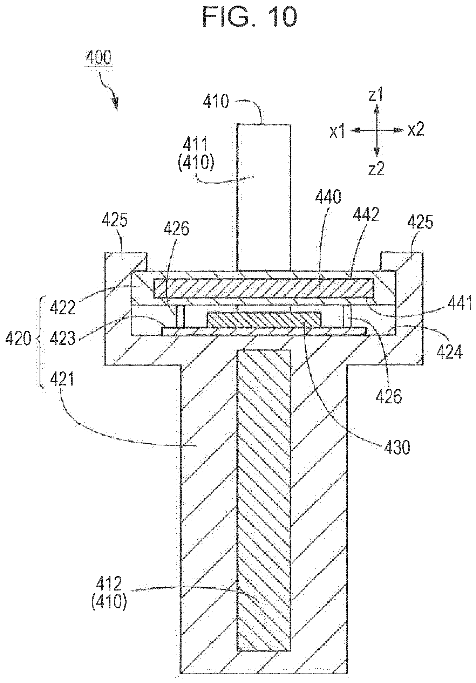

Next, a current sensor according to a second embodiment of the present invention will be described. Fig. 10 is a sectional view of a current sensor 400 according to the second embodiment at the same section as the section of Fig. 2. A wire 410, a normal region 411, a narrow region 412, a securing member 420, a main securing member 421, a first substrate 422, a second substrate 423, an upper surface 424, claws 425, bosses 426, a magnetic sensor 430, a magnetic field shaping member 440, a first outer surface 441, and a second outer surface 442 according to the second embodiment (Fig. 10) respectively correspond to the wire 110, the normal region 111, the narrow region 112, the securing member 120, the main securing member 121, the first substrate 122, the second substrate 123, the upper surface 124, the claws 125, the bosses 126, the magnetic sensor 130, the magnetic field shaping member 140, the first outer surface 141, and the second outer surface 142 according to the first embodiment (Fig. 2).

A significant difference between the first embodiment (Fig. 2) and the second embodiment (Fig. 10) is the positions of the magnetic field shaping member 440 and the magnetic sensor 430. Description below mainly focuses on the difference between the first embodiment (Fig. 2) and the second embodiment (Fig. 10).

As is the case with the first embodiment (Fig. 2), the magnetic field shaping member 440 is embedded inside and secured to the first substrate 422 according to the second embodiment (Fig. 10). As is the case with the first embodiment (Fig. 2), the magnetic sensor 430 is secured to a surface of the second substrate 423 on the z1 side according to the second embodiment (Fig. 10). However, unlike the first embodiment (Fig. 2), the first substrate 422 according to the second embodiment (Fig. 10) is positioned on the z1 side relative to the second substrate 423. The magnetic sensor 430 is positioned between the wire 410 and the magnetic field shaping member 440 in the z direction.

The magnetic field shaping member 440 is a plate-shaped member extending substantially parallel to the xy plane inside the first substrate 422. The magnetic field shaping member 440 is formed of a soft magnetic material. The magnetic field shaping member 440 has a substantially rectangular parallelepiped shape having surfaces, and each of the surfaces of the magnetic field shaping member 440 is parallel to one of the xy plane, yz plane, and the xz plane. The magnetic field shaping member 440 has the first outer surface 441 parallel to the xy plane and located on the z2 side and the second outer surface 442 parallel to the xy plane and located on the z1 side. The first outer surface 441 faces the magnetic sensor 430. Both the direction along the first outer surface 441 and the direction of the sensitivity axis of the magnetic sensor 430 (that is, the x direction) are substantially parallel to the x direction.

The first substrate 422 and the second substrate 423 are heat welded with the bosses 426 interposed therebetween during the production. The first substrate 422 is secured to the main securing member 421 by using the claws 425 with a surface of the second substrate 423 on the z2 side in closed contact with the upper surface 424 of the main securing member 421.

As is the case with the first embodiment (Fig. 2), compared to the case where the magnetic field shaping member 440 is not provided, the vectors of the magnetic field around the magnetic field shaping member 440 according to the second embodiment (Fig. 10) do not significantly change even when the magnetic field shaping member 440 is slightly moved in the x direction. Since the magnetic sensor 430 is secured in the shaped magnetic field on the z2 side relative to the magnetic field shaping member 440, the vectors of the magnetic flux near the magnetic sensor 430 do not significantly change even when the magnetic sensor 430 is slightly moved in the x direction. That is, even when the positions of the magnetic sensor 430 and the wire 410 in the x direction are shifted from each other, the direction of the magnetic field in the magnetic sensor 430 is maintained substantially parallel to the x direction.

### (Summarization)

According to the present embodiment, the effects similar to those of the first embodiment (Fig. 2) can be obtained except for the effects obtained due to the disposition of the magnetic field shaping member 140 according to the first embodiment (Fig. 2) between the wire 110 and the magnetic sensor 130.

According to the present embodiment, the magnetic sensor 430 is positioned between the wire 410 and the magnetic field shaping member 440. Thus, the size can be reduced compared to the case where the magnetic field shaping member 440 is disposed at the same position, that is, the magnetic field shaping member 440 is disposed between the wire 410 and the magnetic sensor 430. Furthermore, since the magnetic field is unlikely to be blocked by the magnetic field shaping member 440, the signal-to-noise ratio can be reduced, and accordingly, a small change of the magnetic field is likely to be detected by the magnetic sensor 430.

### (Third Embodiment)

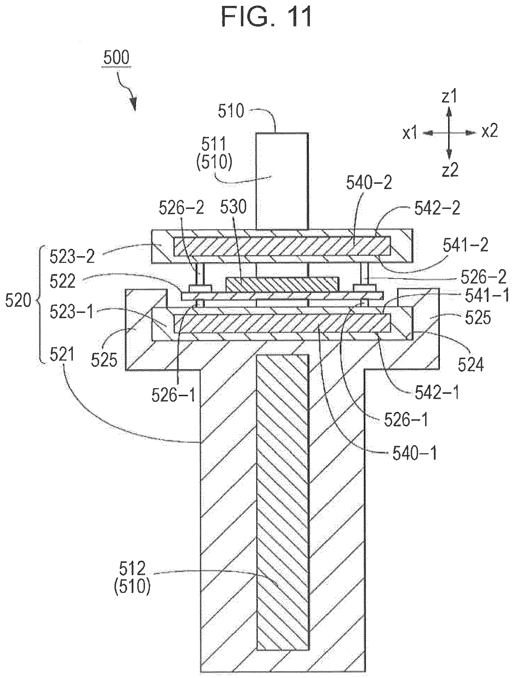

Next, a current sensor according to a third embodiment of the present invention will be described. Fig. 11 is a sectional view of a current sensor 500 according to the third embodiment at the same section as the section of Fig. 2. A wire 510, a normal region 511, a narrow region 512, a securing member 520, a main securing member 521, a first substrate 522, a second proximal substrate 523-1, an upper surface 524, claws 525, proximal bosses 526-1, a magnetic sensor 530, a proximal magnetic field shaping member 540-1, a first proximal outer surface 541-1, and a second proximal outer surface 542-1 according to the third embodiment (Fig. 11) respectively correspond to the wire 110, the normal region 111, the narrow region 112, the securing member 120, the main securing member 121, the first substrate 122, the second substrate 123, the upper surface 124, the claws 125, the bosses 126, the magnetic sensor 130, the magnetic field shaping member 140, the first outer surface 141, and the second outer surface 142 according to the first embodiment (Fig. 2).

A second distal substrate 523-2, distal bosses 526-2, a distal magnetic field shaping member 540-2, a first distal outer surface 541-2, and a second distal outer surface 542-2 according to the third embodiment (Fig. 11) respectively correspond to the second substrate 423, the bosses 426, the magnetic field shaping member 440, the first outer surface 441, and the second outer surface 442 according to the second embodiment (Fig. 10). Hereafter, the proximal magnetic field shaping member 540-1 and the distal magnetic field shaping member 540-2 may be referred to as magnetic field shaping members 540 without being distinguished from each other.

The third embodiment (Fig. 11) has the structure in which the first embodiment (Fig. 2) and the second embodiment (Fig. 10) are combined with each other. The difference between the third embodiment (Fig. 11) and the first embodiment (Fig. 2) or the second embodiment (Fig. 10) is that, according to the third embodiment (Fig. 11), the current sensor 500 includes two magnetic field shaping members 540 and the magnetic sensor 530 is positioned between one of the other magnetic field shaping members 540 and the other magnetic field shaping member 540. Description below mainly focuses on the difference between the current sensor 500 according to the third embodiment (Fig. 11) and the current sensor 100 according to the first embodiment (Fig. 2) or the current sensor 400 according to the second embodiment (Fig. 10).

As is the case with the first embodiment (Fig. 2) and the second embodiment (Fig. 10), compared to the case where the magnetic field shaping members 540 are not provided, the vectors of the magnetic field around the magnetic field shaping members 540 according to the third embodiment (Fig. 11) do not significantly change even when the magnetic field shaping members 540 are slightly moved in the x direction. Since the magnetic sensor 430 is secured in the shaped magnetic field between two magnetic field shaping members 540, the vectors of the magnetic flux near the magnetic sensor 530 do not significantly change even when the magnetic sensor 530 is slightly moved in the x direction. That is, even when the positions of the magnetic sensor 530 and the wire 510 in the x direction are shifted from each other, the direction of the magnetic field in the magnetic sensor 530 is maintained substantially parallel to the x direction. The magnetic sensor 530 is interposed between two magnetic field shaping members 540. Thus, compared to the case where a single magnetic field shaping member 540 is provided, a change in the vectors of the magnetic flux near the magnetic sensor 530 is insignificant when the magnetic sensor 530 and the magnetic field shaping members 540 are moved in the x direction relative to the wire 510.

### (Summarization)

According to the present embodiment, the effects similar to those of the first embodiment (Fig. 2) and the second embodiment (Fig. 10) can be obtained except for the effects obtained due to the disposition of the magnetic field shaping member 140 (or the magnetic field shaping member 440) according to the first embodiment (Fig. 2) or the second embodiment (Fig. 10) only on the one side relative to the magnetic sensor 130 (or the magnetic sensor 430) .

According to the present embodiment, the magnetic field shaping members 540 are positioned between the wire 510 and the magnetic sensor 530. Thus, compared to the case where the magnetic field shaping members 540 are not provided, the magnetic flux density near the magnetic sensor 530 is small, and accordingly, measurement up to a high current can be performed with the magnetic sensor 530. Furthermore, the magnetic field shaping members 540 are disposed on both sides relative the magnetic sensor 530. Thus, compared to the case where a single magnetic field shaping member 540 is provided, the change in the vectors of the magnetic flux near the magnetic sensor 530 due to a positional shift is insignificant.

The present invention is not limited to the above-described embodiments.

### Industrial Applicability

The present invention can be applied to various current sensors.

### Reference Signs List

- 100: current sensor
- 110: wire
- 120: securing member
- 122: first substrate
- 123: second substrate
- 130: magnetic sensor
- 140: magnetic field shaping member
- 141: first outer surface
- 222: first substrate
- 223: second substrate
- 230: magnetic sensor
- 240: magnetic field shaping member
- 322: first substrate
- 323: second substrate
- 326: retaining claw
- 330: magnetic sensor
- 340: magnetic field shaping member
- 400: current sensor
- 410: wire
- 420: securing member
- 422: first substrate
- 423: second substrate
- 430: magnetic sensor
- 440: magnetic field shaping member
- 441: first outer surface
- 500: current sensor
- 510: wire
- 520: securing member
- 522: first substrate
- 523-1: second proximal substrate
- 523-2: second distal substrate
- 530: magnetic sensor
- 540-1: proximal magnetic field shaping member
- 540-2: distal magnetic field shaping member
- 541-1: first proximal outer surface
- 541-2: first distal outer surface

## Claims

1. A current sensor comprising:
a wire (110) that has a thickness in a first direction and a width which is in a second direction perpendicular to the first direction and which is larger than the thickness;
a magnetic sensor (130) that detects a magnetic field generated by a current flowing through the wire (110);
at least one magnetic field shaping member (140) that includes a soft magnetic material and that shapes the magnetic field; and
a securing member (120) that secures the wire (110), the magnetic sensor (130), and the at least one magnetic field shaping member (140),
wherein the at least one magnetic field shaping member (140) is a plate-shaped member extending substantially parallel to a plane perpendicular to the second direction,
wherein the at least one magnetic field shaping member includes an outer surface facing the magnetic sensor,
wherein a direction along the outer surface and a direction of a sensitivity axis of the magnetic sensor are substantially parallel to the first direction,
wherein the securing member (120) secures the magnetic sensor and the at least one magnetic field shaping member on a same side in the second direction relative to the wire (110) such that the magnetic sensor and the at least one magnetic field shaping member are located close to each other, and
wherein the securing member (120) secures the wire, the magnetic sensor, and the at least one magnetic field shaping member such that the wire, the magnetic sensor, and the at least one magnetic field shaping member are kept separated from one another in the second direction while at least part of the wire (110), at least part of the magnetic sensor (130), and at least part of the at least one magnetic field shaping member (140) are superposed on one another in the second direction,
wherein the at least one magnetic field shaping member (140) is positioned between the wire (110) and the magnetic sensor.

2. The current sensor according to Claim 1,
wherein the magnetic sensor (130) is disposed near or at a center of the at least one magnetic field shaping member (140) in the first direction.

3. The current sensor according to Claim 1 or 2,
wherein a width of the at least one magnetic field shaping member (140) in the first direction is larger than the thickness of the wire (110) in the first direction.

4. The current sensor according to any one of Claims 1 to 3,
wherein the at least one magnetic field shaping member (140) includes two magnetic field shaping members, and
wherein the magnetic sensor (130) is positioned between one of the magnetic field shaping members and another magnetic field shaping member.

5. The current sensor according to any one of Claims 1 to 4,
wherein the securing member (120) includes a first substrate and a second substrate,
wherein the at least one magnetic field shaping member (140) is secured to the first substrate,
wherein the magnetic sensor (130) is secured to the second substrate, and
wherein the first substrate and the second substrate are secured to each other by heat welding.

## Patentansprüche

1. Stromsensor, umfassend:
einen Draht (110), der eine Dicke in einer ersten Richtung und eine Breite, die in einer zweiten Richtung senkrecht zu der ersten Richtung liegt und die größer ist als die Dicke, aufweist;
einen Magnetsensor (130), der ein Magnetfeld erfasst, das durch einen durch den Draht (110) fließenden Strom erzeugt wird;
mindestens ein Magnetfeld-Formungselement (140), welches ein weiches magnetisches Material aufweist und welches das Magnetfeld formt; und
ein Befestigungselement (120), das den Draht (110), den Magnetsensor (130) und das mindestens eine Magnetfeld-Formungselement (140) befestigt,
wobei das mindestens eine Magnetfeld-Formungselement (140) ein plattenförmiges Element ist, das sich im Wesentlichen parallel zu einer Ebene senkrecht zu der zweiten Richtung erstreckt,
wobei das mindestens eine Magnetfeld-Formungselement eine äußere Fläche aufweist, die dem Magnetsensor zugewandt ist, wobei eine Richtung entlang der äußeren Fläche und eine Richtung einer Empfindlichkeitsachse des Magnetsensors im Wesentlichen parallel zu der ersten Richtung sind,
wobei das Befestigungselement (120) den Magnetsensor und das mindestens eine Magnetfeld-Formungselement auf einer selben Seite in der zweiten Richtung relativ zu dem Draht (110) derart befestigt, dass sich der Magnetsensor und das mindestens eine Magnetfeld-Formungselement nahe beieinander befinden, und
wobei das Befestigungselement (120) den Draht, den Magnetsensor und das mindestens eine Magnetfeld-Formungselement derart befestigt, dass der Draht, der Magnetsensor und das mindestens eine Magnetfeld-Formungselement voneinander in der zweiten Richtung getrennt gehalten sind, während mindestens ein Teil des Drahts (110), mindestens ein Teil des Magnetsensors (130) und mindestens ein Teil des mindestens einen Magnetfeld-Formungselements (140) einander in der zweiten Richtung überlagern, wobei das mindestens eine Magnetfeld-Formungselement (140) zwischen dem Draht (110) und dem Magnetsensor positioniert ist.

2. Stromsensor nach Anspruch 1,
wobei der Magnetsensor (130) in der Nähe oder in einer Mitte des mindestens einen Magnetfeld-Formungselements (140) in der ersten Richtung angeordnet ist.

3. Stromsensor nach Anspruch 1 oder 2,
wobei eine Breite des mindestens einen Magnetfeld-Formungselements (140) in der ersten Richtung größer ist als die Dicke des Drahts (110) in der ersten Richtung.

4. Stromsensor nach einem der Ansprüche 1 bis 3,
wobei das mindestens eine Magnetfeld-Formungselement (140) zwei Magnetfeld-Formungselemente aufweist, und
wobei der Magnetsensor (130) zwischen einem der Magnetfeld-Formungselemente und einem anderen Magnetfeld-Formungselement positioniert ist.

5. Stromsensor nach einem der Ansprüche 1 bis 4,
wobei das Befestigungselement (120) ein erstes Substrat und ein zweites Substrat aufweist,
wobei das mindestens eine Magnetfeld-Formungselement (140) an dem ersten Substrat befestigt ist,
wobei der Magnetsensor (130) an dem zweiten Substrat befestigt ist, und
wobei das erste Substrat und das zweite Substrat aneinander durch Wärmeschweißen befestigt sind.

## Revendications

1. Capteur de courant, comprenant :
un fil (110) qui présente une épaisseur dans une première direction et une largeur qui est dans une seconde direction perpendiculaire à la première direction et qui est plus grande que l'épaisseur ;
un capteur magnétique (130) qui détecte un champ magnétique généré par un courant circulant à travers le fil (110) ;
au moins un organe de mise en forme de champ magnétique (140) qui comporte un matériau magnétique souple et qui met en forme le champ magnétique ; et
un organe de fixation (120) qui fixe le fil (110), le capteur magnétique (130), et l'au moins un organe de mise en forme de champ magnétique (140),
dans lequel l'au moins un organe de mise en forme de champ magnétique (140) est un organe en forme de plaque s'étendant sensiblement parallèlement à un plan perpendiculaire à la seconde direction,
dans lequel l'au moins un organe de mise en forme de champ magnétique comporte une surface externe en face du capteur magnétique,
dans lequel une direction le long de la surface externe et une direction le long d'un axe de sensibilité du capteur magnétique sont sensiblement parallèles à la première direction,
dans lequel l'organe de fixation (120) fixe le capteur magnétique et l'au moins un organe de mise en forme de champ magnétique sur un même côté dans la seconde direction par rapport au fil (110) de sorte que le capteur magnétique et l'au moins un organe de mise en forme de champ magnétique soient situés plus proches l'un de l'autre, et
dans lequel l'organe de fixation (120) fixe le fil, le capteur magnétique, et l'au moins un organe de mise en forme de champ magnétique de sorte que le fil, le capteur magnétique, et l'au moins un organe de mise en forme de champ magnétique soient maintenus séparés les uns des autres dans la seconde direction tandis qu'au moins une partie du fil (110), au moins une partie du capteur magnétique (130), et au moins une partie de l'au moins un organe de mise en forme de champ magnétique (140) sont superposées les unes sur les autres dans la seconde direction,
dans lequel l'au moins un organe de mise en forme de champ magnétique (140) est positionné entre le fil (110) et le capteur magnétique.

2. Capteur de courant selon la revendication 1,
dans lequel le capteur magnétique (130) est disposé à proximité ou au niveau d'un centre de l'au moins un organe de mise en forme de champ magnétique (140) dans la première direction.

3. Capteur de courant selon la revendication 1 ou 2,
dans lequel une largeur de l'au moins un organe de mise en forme de champ magnétique (140) dans la première direction est plus grande que l'épaisseur du fil (110) dans la première direction.

4. Capteur de courant selon l'une quelconque des revendications 1 à 3,
dans lequel l'au moins un organe de mise en forme de champ magnétique (140) comporte deux organes de mise en forme de champ magnétique, et
dans lequel le capteur magnétique (130) est positionné entre l'un des organes de mise en forme de champ magnétique et un autre organe de mise en forme de champ magnétique.

5. Capteur de courant selon l'une quelconque des revendications 1 à 4,
dans lequel l'organe de fixation (120) comporte un premier substrat et un second substrat,
dans lequel l'au moins un organe de mise en forme de champ magnétique (140) est fixé au premier substrat,
dans lequel le capteur magnétique (130) est fixé au second substrat, et
dans lequel le premier substrat et le second substrat sont fixés l'un à l'autre par thermosoudage.
